(19) **Europäisches Patentamt / European Patent Office / Office européen des brevets**

(11) **EP 3 803 018 B1**

(12) **FASCICULE DE BREVET EUROPEEN**

(45) Date de publication et mention de la délivrance du brevet:
**08.05.2024 Bulletin 2024/19**

(21) Numéro de dépôt: **19737826.8**

(22) Date de dépôt: **28.05.2019**

(51) Classification Internationale des Brevets (IPC):
**E06B 5/20** (2006.01)   **E06B 3/67** (2006.01)

(52) Classification Coopérative des Brevets (CPC):
**E06B 5/20; E06B 3/6707;** E06B 5/205;
H10N 30/10513

(86) Numéro de dépôt international:
**PCT/FR2019/051229**

(87) Numéro de publication internationale:
**WO 2019/229351 (05.12.2019 Gazette 2019/49)**

(54) **VITRAGE AYANT DES PERFORMANCES ACOUSTIQUES AMELIORÉES**

VERGLASUNG MIT VERBESSERTER AKUSTISCHER LEISTUNG

GLAZING HAVING IMPROVED ACOUSTIC PERFORMANCE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats de validation désignés:
**MA**

(30) Priorité: **31.05.2018 FR 1870630**

(43) Date de publication de la demande:
**14.04.2021 Bulletin 2021/15**

(73) Titulaire: **Saint-Gobain Glass France
92400 Courbevoie (FR)**

(72) Inventeurs:
• **MICHAU, Marc
75018 PARIS (FR)**
• **BOUILLET, Fabien
60200 COMPIEGNE (FR)**
• **DIGUET, Antoine
75009 PARIS (FR)**

(74) Mandataire: **Saint-Gobain Recherche
B.P. 135
39, quai Lucien Lefranc
93303 Aubervilliers Cedex (FR)**

(56) Documents cités:
**WO-A1-2013/164540    US-A1- 2018 062 062**

EP 3 803 018 B1

**Description**

L'invention concerne un vitrage ayant des performances acoustiques améliorées.

Dans les véhicules automobiles, il est connu d'utiliser des vitrages feuilletés avec un intercalaire en PVB dit acoustique, au lieu d'un intercalaire en PVB standard, pour améliorer les performances acoustiques du vitrage. L'intercalaire en PVB acoustique est par exemple un intercalaire tri-couche comprenant deux couches externes en PVB ayant des propriétés acoustiques banales (PVB standard) entre lesquelles est disposée une couche centrale moins rigide que les couches externes, qui est à base de PVB et qui contient plus de plastifiant que le PVB standard. Toutefois, ce type d'intercalaire ne permet pas d'amortir les ondes acoustiques de façon équivalente sur l'ensemble des fréquences audibles.

Dans les bâtiments, l'isolation acoustique des vitrages est également très importante pour atténuer au maximum les bruits extérieurs.

En particulier, l'oreille humaine est particulièrement sensible dans une bande de fréquences comprise entre 1000 Hz et 4000 Hz. Or, dans cette bande de fréquences, l'amortissement acoustique n'est pas toujours optimum sur les vitrages automobile ou bâtiment.

WO 2013/164540 A1 divulgue un vitrage ayant des performances acoustiques améliorées selon le préambule de la revendication 1.

Il y a donc un besoin pour un vitrage ayant des performances acoustiques améliorées sur les fréquences audibles, en particulier entre 1000 Hz et 4000 Hz, sans perte de champ de vision par rapport aux vitrages existants.

Pour cela, l'invention propose un vitrage ayant des performances acoustiques améliorées, le vitrage comprenant au moins un substrat transparent comportant sur au moins une de ses faces un réseau, de préférence périodique, de transducteurs piézoélectriques transparents et le vitrage comprenant une pluralité de circuits électriques résonants, chaque transducteur piézoélectrique transparent étant relié à un seul circuit électrique résonant de manière à ce que le substrat transparent forme un méta-matériau transparent.

Selon une autre particularité, chaque circuit électrique résonant est un circuit passif ou semi-passif.

Selon une autre particularité, chaque circuit électrique résonant comprend au moins une inductance, l'inductance étant, soit une bobine, soit une inductance de synthèse.

Selon une autre particularité, chaque circuit électrique résonant comprend en outre une capacitance de synthèse négative.

Selon une autre particularité, chaque circuit électrique résonant comprend en outre une résistance.

Selon une autre particularité, chaque circuit électrique résonant est en outre adaptatif par réglage de l'inductance et/ou de la capacitance.

Selon une autre particularité, chaque circuit électrique résonant (est un circuit électrique multi-résonnant.

Selon une autre particularité, les circuits électriques résonants sont situés sur une carte électronique qui est déportée par rapport au substrat transparent.

Selon une autre particularité, le vitrage comprend entre 10 et 1000 transducteurs piézoélectriques transparents par m$^2$, de préférence entre 10 et 200 par m$^2$.

Selon une autre particularité, chaque transducteur piézoélectrique transparent (3) a une surface comprise entre 1 et 100 cm$^2$, de préférence entre 1 et 25 cm$^2$.

Selon une autre particularité, chaque transducteur piézoélectrique transparent a une épaisseur totale comprise entre 1 $\mu$m et 1 mm, de préférence entre 10 $\mu$m et 1mm, voire entre 10 $\mu$m et 500 $\mu$m.

Selon une autre particularité, l'espace entre deux transducteurs piézoélectriques transparents adjacents est compris entre 0,5 cm et 50 cm, de préférence entre 1 cm et 15 cm.

Selon une autre particularité, le substrat transparent comporte un réseau, de préférence périodique, de transducteurs piézoélectriques transparents sur chacune de ses faces, les transducteurs piézoélectriques transparents étant situés en vis-à-vis les uns des autres sur ses deux faces et chaque paire de transducteurs piézoélectriques transparents situés en vis-à-vis étant reliés au même circuit électrique résonant.

Selon une autre particularité, chaque transducteur piézoélectrique transparent est à base d'oxyde de zinc, ou d'oxyde de titane et de baryum de type BaTiO$_3$, ou de nitrure d'aluminium, ou de Titano-Zirconate de Plomb (PZT), ou de polyfluorure de vinylidène (PVDF), ou de Titano-Zirconate de Plomb dopé au Lanthane (PLZT), ou encore de copolymère à bloc de poly(styrène-b-isoprène).

Selon une autre particularité, le au moins un substrat transparent, comprend :

- une première électrode transparente sous forme d'une couche mince disposée sur toute la surface du substrat transparent, ou une pluralité de premières électrodes transparentes sous forme d'une pluralité de portions de couche mince réparties de façon matricielle sur toute la surface du substrat transparent,

- un élément piézoélectrique transparent sous forme d'une couche mince disposée sur toute la surface du substrat transparent, ou une pluralité d'éléments piézoélectriques transparents sous forme d'une pluralité de portions de couche mince réparties de façon matricielle, chaque élément piézoélectrique transparent étant disposé sur la première électrode transparente sous forme de couche mince ou sur une seule première électrode transparente sous forme d'une portion de couche mince, les éléments piézoélectriques transparents répartis de façon matricielle étant de préférence isolés les uns des autres par un matériau isolant,

- une pluralité de deuxièmes électrodes transparentes sous forme d'une pluralité de portions de couche mince réparties de façon matricielle, chaque deuxième électrode transparente étant disposée sur un seul élément piézoélectrique transparent ou au-dessus d'une seule première électrode transparente recouverte de l'élément piézoélectrique sous forme d'une couche mince disposée sur toute la surface du substrat transparent,

Selon une autre particularité, chaque électrode transparente est constituée d'un empilement de couches minces comprenant au moins une couche mince en oxyde transparent conducteur, par exemple en oxyde de titane, et/ou une couche mince métallique.

Selon une autre particularité, au moins une couche mince diélectrique est disposée entre chaque première et deuxième électrodes transparentes et le ou les éléments piézoélectriques transparents.

Selon une autre particularité, le vitrage est constitué d'un vitrage feuilleté comprenant le substrat transparent formant un méta-matériau, un intercalaire en matériau viscoélastique, de préférence à base de polyvynibutyral, et un substrat transparent ou un deuxième substrat transparent formant un méta-matériau, les transducteurs piézoélectriques transparents étant de préférence sur une face du substrat qui est en vis-à-vis de l'intercalaire.

Selon une autre particularité, le vitrage est constitué d'un vitrage isolant comprenant le substrat transparent formant un méta-matériau, et un substrat transparent ou un deuxième substrat transparent formant un méta-matériau, espacés par une lame d'air ou une lame de gaz, les transducteurs piézoélectriques transparents étant de préférence sur une face du substrat qui est en vis-à-vis de la lame d'air ou de la lame de gaz.

D'autres caractéristiques et avantages de l'invention vont à présent être décrits en regard des dessins sur lesquels :

[Fig.1] représente une vue en coupe d'un vitrage selon l'invention, avec des transducteurs piézoélectriques transparents sur une seule face du substrat transparent ;

[Fig.2] représente une vue de face d'un vitrage selon l'invention ;

[Fig.3] représente une vue en coupe d'un vitrage selon l'invention, avec des transducteurs piézoélectriques transparents sur les deux faces du même substrat transparent ;

[Fig.4] représente une vue en coupe d'un vitrage feuilleté selon l'invention, avec des transducteurs piézoélectriques transparents sur une seule face d'un substrat transparent ;

[Fig.5] représente un exemple d'inductance de synthèse ;

[Fig.6] représente un exemple de capacitance de synthèse négative.

Les numéros de référence qui sont identiques sur les différentes figures représentent des éléments similaires ou identiques.

Un substrat transparent est défini comme un substrat à fonction verrière, notamment en verre sodocalcique ou en plastique par exemple de type polyéthylène téréphtalate (PET), polyéthylène naphtalate (PEN), polycarbonate (PC), polyméthylmétacrylate (PMMA) ou encore poly(éthylène-co-tetrafluoroéthylène) (ETFE).

Le terme « transparent » définit une transmission totale (directe et diffuse) supérieure à 1%, et de préférence supérieure à 40 %, pour des longueurs d'onde visibles de l'œil humain, à partir d'un spectre composé de raies discrètes et/ou continues. Ces longueurs d'onde visibles sont comprises entre 350 et 800 nm.

Un transducteur piézoélectrique comprend un matériau piézoélectrique disposé entre deux électrodes et est adapté à transformer un signal électrique en un mouvement mécanique et inversement.

L'invention se rapporte à un vitrage ayant des performances acoustiques améliorées, le vitrage comprenant au moins un substrat transparent comportant sur au moins une de ses faces un réseau, de préférence périodique, de transducteurs piézoélectriques transparents et une pluralité de circuits électriques résonants, chaque transducteur piézoélectrique étant relié à un seul circuit électrique résonant de manière à ce que le substrat forme un méta-matériau transparent.

Les inventeurs ont mis en évidence que chaque transducteur piézoélectrique relié à un circuit électrique résonnant est équivalent à un système ressort/masse, mais beaucoup plus léger et transparent. La pluralité de ces systèmes transducteur piézoélectrique/circuit résonant sur le substrat en fait un méta-matériau permettant d'améliorer l'isolation acoustique du substrat sur une bande de fréquences dans le domaine audible. En outre, les transducteurs piézoélectriques étant transparents, le vitrage reste transparent. Il n'y a donc pas de perte de champ de vision.

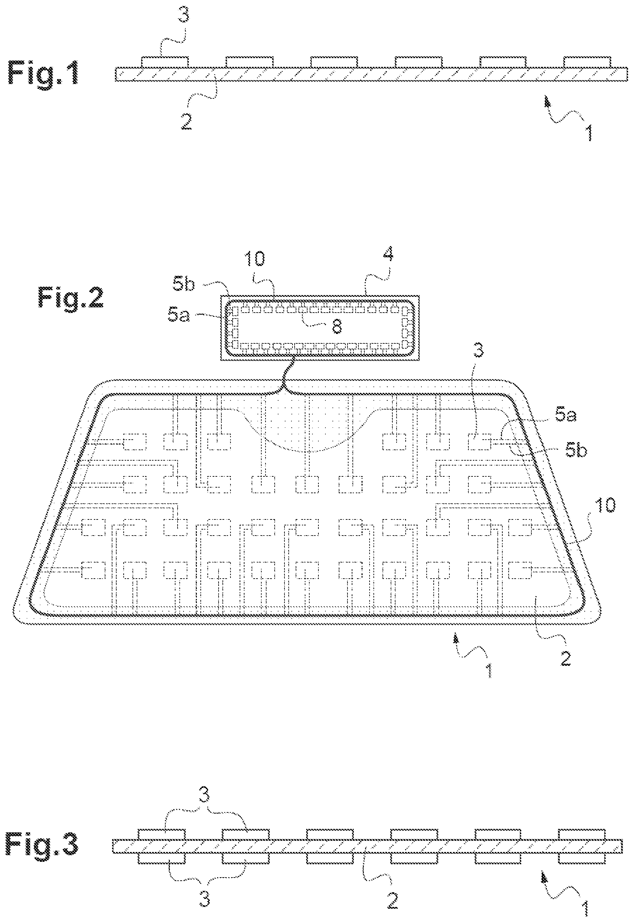

La figure 1 représente une vue en coupe d'un vitrage 1 selon l'invention, avec des transducteurs piézoélectriques transparents 3 sur une seule face du substrat transparent 2.

La Figure 2 représente une vue de face d'un pare-brise constitué d'un vitrage selon l'invention.

Sur la figure 1, le vitrage 1 comporte un seul substrat 2, en verre organique ou inorganique, sur la surface duquel est répartie une pluralité de transducteurs piézoélectriques transparents 3, de préférence de façon périodique.

Le vitrage 1 comporte également une pluralité de circuits électriques résonants 8, tous les circuits électriques résonants 8 étant de préférence situés sur une carte électronique 4 déportée par rapport au substrat 2. Chaque transducteur piézoélectrique transparent 3 est relié à un seul circuit électrique résonant 8 via deux fils conducteurs 5a, 5b. L'ensemble des fils conducteurs 5a, 5b se rejoint de préférence sur un pourtour sérigraphié du vitrage en un paquet 10 qui se poursuit jusqu'à la carte électronique 4.

Dans le mode de réalisation de la figure 1, il y a autant de circuits électriques résonants que de transducteurs piézoélectriques transparents 3 et que de paires de fils conducteurs 5a, 5b reliant chaque transducteur piézoélectrique transparent 3 à son circuit électrique résonant 8. La carte électronique 4 peut être cachée dans l'habitacle d'un véhicule, par exemple dans son tableau de bord, ou derrière une cloison en plâtre d'un bâtiment.

Chaque couple transducteur piézoélectrique/circuit électrique résonant est l'équivalent d'un système ressort/masse, dont l'on sait bien qu'il permet d'améliorer l'isolation du support à une fréquence donnée. La pluralité de couples de ce type, répartis, de préférence de façon périodique, sur le substrat, transforme ce dernier en méta-matériau, ce qui permet alors d'améliorer l'isolation acoustique sur une bande de fréquences.

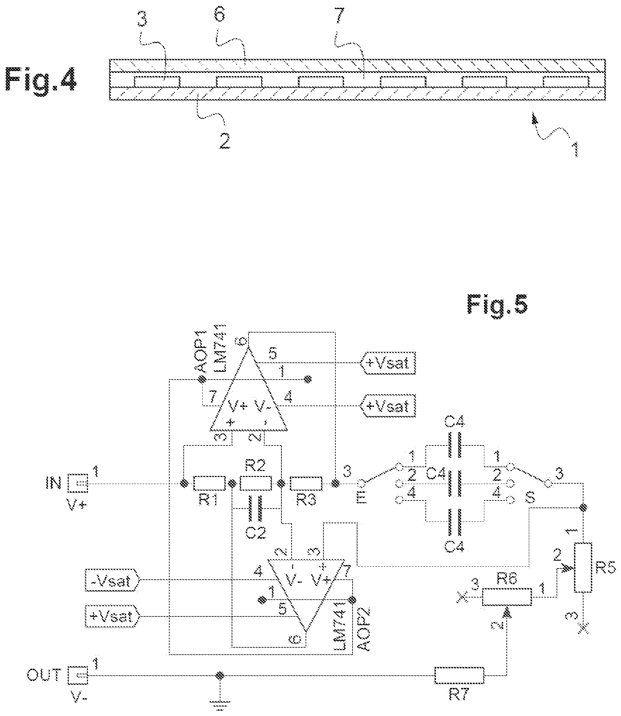

Chaque circuit électrique résonant 8 comprend au moins une inductance, l'inductance étant, soit une bobine, soit une inductance de synthèse. Chaque transducteur piézoélectrique transparent 3 agit comme une capacité. La capacité est l'équivalent du ressort d'un système ressort/masse et l'inductance est l'équivalent de la masse d'un système ressort/masse. Pour gagner en place et en poids, l'inductance de synthèse est toutefois préférée à la bobine. L'inductance de synthèse est par exemple du type Antoniou. Un exemple d'inductance de synthèse est représenté sur la figure 5.

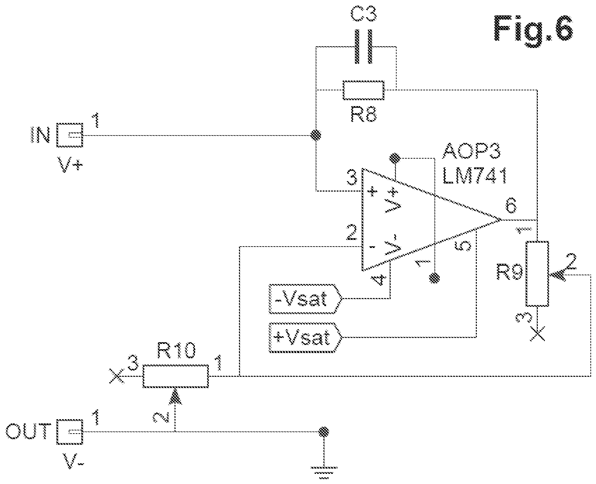

Chaque circuit électrique résonant 8 peut en outre comprendre une capacitance de synthèse négative, qui est choisie en fonction de la capacitance du transducteur piézoélectrique. En effet, la capacitance du transducteur piézoélectrique transparent 3 est parfois trop élevée par rapport aux besoins. La capacitance de synthèse négative permet d'avoir une capacitance résultante équivalente $C_{eq}$ qui est alors inférieure à la capacitance du transducteur piézoélectrique transparent 3 seul, ce qui permet de mieux répondre aux besoins en termes d'amélioration de l'isolation acoustique. Un exemple de capacitance négative est représenté sur la figure 6.

La bande de fréquences interdite, qui correspond à la bande de fréquences dans laquelle l'on souhaite améliorer l'isolation acoustique, commence à la fréquence de résonance $f_R$. La fréquence de résonance $f_R$ est déterminée par la formule suivante :

$$f_R = \frac{1}{2\pi} \cdot \sqrt{\frac{1}{L_{eq} \cdot C_{eq}}}$$

où $L_{eq}$ est la valeur de l'inductance réalisée avec une bobine classique ou avec une inductance de synthèse, et où $C_{eq}$ est égale, soit à la capacitance du transducteur piézoélectrique transparent seul, soit à la somme de la capacitance du transducteur piézoélectrique transparent et de la capacitance de synthèse négative. Afin de garantir la stabilité du système, il faut vérifier $C_{eq}>0$.

La valeur de l'inductance de synthèse, et éventuellement celle de la capacitance négative, sont alors fixées en fonction de la fréquence de résonance que l'on souhaite, par exemple 1000 Hz si l'on souhaite améliorer l'isolation acoustique sur une bande de fréquences à partir de 1000 Hz.

Chaque circuit électrique résonant 8 peut en outre comprendre une résistance électrique. La présence d'une résistance dans le circuit électrique résonant permet d'adapter le facteur de qualité de la résonance.

Tous les transducteurs piézoélectriques transparents 3 sont identiques et tous les circuits électriques résonants 8 sont identiques afin de pouvoir réaliser le méta-matériau.

Chaque circuit électrique résonant 8 peut en outre être adaptatif par réglage de l'inductance de synthèse et/ou de la capacitance de synthèse. Ce réglage est réalisé en fonction de la bande interdite préférentielle selon la formule citée plus haut. Pour ce faire, le circuit de l'inductance de synthèse et/ou celui de la capacitance de synthèse comprennent par exemple une résistance réglable. Le fait que chaque circuit électrique résonant 8 soit adaptatif permet de s'adapter aux différents bruits auxquels on peut être confrontés ou au cahier des charges du projet.

Chaque circuit électrique résonant 8 peut en outre être un circuit électrique multi-résonant. Cela permet d'élargir la bande de fréquences sur laquelle l'isolation acoustique est améliorée, en ayant au moins deux bandes interdites. Dans ce cas, chaque circuit électrique résonant peut par exemple comprendre au moins deux bobines ou deux inductances de synthèse, de préférence reliées deux à deux par une capacitance pour éviter les interférences entre les différentes inductances. Chaque circuit électrique multi-résonant comprend de préférence au maximum cinq résonances.

Chaque circuit électrique résonant 8 est un circuit passif ou semi-passif. En effet, il est passif dans le cas où il ne comporte qu'une ou plusieurs bobines et il est semi-passif dans le cas où il comporte au moins un composant de synthèse. En effet, les composants de synthèse comportent des amplificateurs opérationnels qui, pour fonctionner, ont besoin d'être alimentés par une petite quantité de courant électrique. Le système de l'invention n'a donc rien à voir avec l'atténuation active. Le méta-matériau de l'invention, formé par le réseau, de préférence périodique, de transducteurs piézoélectriques transparents 3 reliés chacun à un circuit électrique résonant, capte les mouvements du substrat et modifie ces mouvements en réponse de manière passive ou semi-passive, comme le ferait un réseau de système ressort/masse, qui est également un système passif. Comme on n'apporte pas d'énergie dans le système, on ne risque pas d'avoir des instabilités, contrairement à un système de contrôle actif.

Le vitrage 1 comprend par exemple entre 10 et 1000 transducteurs piézoélectriques transparents par $m^2$, de préférence entre 10 et 500 par $m^2$, voire entre 10 et 200 par $m^2$ de façon à avoir une largeur de bande de fréquences interdite la plus adéquate possible. Chaque transducteur piézoélectrique transparent 3 a une surface comprise par exemple entre 1 et 100 $cm^2$, de préférence entre 1 et 25 $cm^2$, de façon à avoir une largeur de bande de fréquences interdite la plus adéquate possible.

Chaque transducteur piézoélectrique transparent 3 a par exemple une épaisseur totale comprise entre 1 $\mu$m et 1 mm, de préférence entre 10 $\mu$m et 1mm, voire entre 10 $\mu$m et 500 $\mu$m de façon à avoir une largeur de bande de fréquences interdite la plus adéquate possible.

L'espace entre deux transducteurs piézoélectriques transparents 3 adjacents est par exemple compris entre 0,5 cm et 50 cm, de préférence entre 1 cm et 15 cm de façon à avoir une largeur de bande de fréquences interdite la plus adéquate possible.

Chaque transducteur piézoélectrique transparent 3 est par exemple à base d'oxyde de zinc, ou d'oxyde de titane et de baryum de type $BaTiO_3$, ou de nitrure d'aluminium, ou de Titano-Zirconate de Plomb (PZT), ou de polyfluorure de vinylidène (PVDF), ou de Titano-Zirconate de Plomb dopé au Lanthane (PLZT), ou encore de copolymère à bloc de poly(styrène-b-isoprène).Chaque première électrode est connectée à un des fils conducteurs 5a, 5b et chaque deuxième électrode est reliée à l'autre fil conducteur 5b, 5a.

Afin de réaliser le réseau de transducteurs piézoélectriques transparents 3, chaque substrat transparent 2 comprend :

- une première électrode transparente sous forme d'une couche mince disposée sur toute la surface du substrat transparent, ou une pluralité de premières électrodes transparentes sous forme d'une pluralité de portions de couche mince réparties de façon matricielle sur toute la surface du substrat transparent,
- un élément piézoélectrique transparent sous forme d'une couche mince disposée sur toute la surface du substrat transparent, ou une pluralité d'éléments piézoélectriques transparents sous forme d'une pluralité de portions de couche mince réparties de façon matricielle, chaque élément piézoélectrique transparent étant disposé sur la première électrode transparente sous forme de couche mince ou sur une seule première électrode transparente sous forme d'une portion de couche mince, les éléments piézoélectriques transparents répartis de façon matricielle étant de préférence isolés les uns des autres par un matériau isolant,
- une pluralité de deuxièmes électrodes transparentes sous forme d'une pluralité de portions de couche mince réparties de façon matricielle, chaque deuxième électrode transparente étant disposée sur un seul élément piézoélectrique transparent ou au-dessus d'une seule première électrode transparente recouverte de l'élément piézoélectrique sous forme d'une couche mince disposée sur toute la surface du substrat transparent.

Chaque électrode transparente est constituée d'un empilement de couches minces comprenant au moins une couche mince en oxyde transparent conducteur, par exemple en oxyde de titane, et/ou une couche mince métallique.

De préférence, au moins une couche mince diélectrique est disposée entre chaque première et deuxième électrodes transparentes et le ou les éléments piézoélectriques transparents.

La Figure 3 représente une vue en coupe d'un vitrage selon l'invention, avec des transducteurs piézoélectriques transparents 3 sur les deux faces du même substrat transparent 2. Sur cette figure, le vitrage 1 comporte toujours un seul substrat 2, en verre organique ou inorganique, mais cette fois une pluralité de transducteurs piézoélectriques transparents 3 est répartie, de préférence de façon périodique, sur les deux faces du substrat transparent 2. Comme dans le cas de la figure 1, le vitrage 1 comporte une pluralité de circuits électriques résonants 8, tous les circuits électriques résonants étant de préférence situés sur une carte électronique 4 déporté par rapport au substrat 2. Chaque transducteur piézoélectrique transparent 3 est relié à un seul circuit électrique résonant 8 via deux fils conducteurs 5a, 5b. Dans le mode de réalisation de la Figure 3, il y a autant que deux fois plus de transducteurs piézoélectriques transparents 3 et de paires de fils conducteurs 5a, 5b reliant chaque transducteur piézoélectrique transparent 3 à son circuit électrique résonant 8 que de circuits électriques résonants 8. Les transducteurs piézoélectriques transparents 3 sont situés en vis-à-vis les uns des autres sur ses deux faces du substrat transparent 2. Chaque paire de transducteurs piézoélectriques transparents 3 situés en vis-à-vis l'un de l'autre est reliée à un même circuit électrique résonant. Ainsi, deux transducteurs piézoélectriques transparents 3 voyant la même déformation du substrat 3, puisqu'ils sont au même endroit de ce dernier, sont reliés au même circuit électrique résonant 8. Cela permet d'augmenter l'efficacité du système et d'augmenter la bande de fréquences interdite.

Le vitrage selon l'invention peut être utilisé dans un véhicule ou dans un bâtiment, sous forme d'un substrat unique ou le substrat étant intégré dans un vitrage feuilleté ou isolant.

La Figure 4 représente une vue en coupe d'un vitrage feuilleté selon l'invention, avec des transducteurs piézoélectriques transparents 3 sur une seule face d'un substrat transparent 2. Le vitrage 1 est un vitrage feuilleté comprenant le substrat transparent 2 formant un méta-matériau, ainsi qu'un substrat transparent 6 classique, le substrat 2 et le substrat 6 étant feuilleté grâce à un intercalaire 7 en matériau viscoélastique, par exemple à base de polyvinylbutyral. En variante, le substrat transparent classique est remplacé par un deuxième substrat transparent formant un méta-matériau. Dans ce mode de réalisation, les transducteurs piézoélectriques transparents 3 sont de préférence situés sur une face du ou des substrats qui est en vis-à-vis de l'intercalaire.

Le vitrage 1 peut également être constitué d'un vitrage isolant comprenant le substrat transparent 2 formant un méta-matériau, et un substrat transparent classique ou un deuxième substrat transparent 3 formant un méta-matériau, espacés par une lame d'air ou une lame de gaz, les transducteurs piézoélectriques transparents 3 étant de préférence sur une face du ou des substrats qui est en vis-à-vis de la lame d'air ou de la lame de gaz.

**Revendications**

1. Vitrage (1) ayant des performances acoustiques améliorées, le vitrage (1) comprenant au moins un substrat transparent (2) comportant sur au moins une de ses faces un réseau, de préférence périodique, de transducteurs piézoélectriques transparents (3),
   **caractérisé en ce que**
   le vitrage comprend une pluralité de circuits électriques résonants (8), chaque transducteur piézoélectrique transparent (3) étant relié à un seul circuit électrique résonant (8) de manière à ce que le substrat transparent (2) forme un méta-matériau transparent.

2. Vitrage (1) selon la revendication 1, dans lequel chaque circuit électrique résonant (8) est un circuit passif ou semi-passif.

3. Vitrage (1) selon la revendication 2, dans lequel chaque circuit électrique résonant (8) comprend au moins une inductance, l'inductance étant, soit une bobine, soit une inductance de synthèse.

4. Vitrage (1) selon la revendication 3, dans lequel chaque circuit électrique résonant (8) comprend en outre une capacitance de synthèse négative.

5. Vitrage (1) selon l'une des revendications 3 ou 4, dans lequel chaque circuit électrique résonant (8) comprend en outre une résistance.

6. Vitrage (1) selon l'une des revendications 3 à 5, dans lequel chaque circuit électrique résonant (8) est en outre adaptatif par réglage de l'inductance et/ou de la capacitance.

7. Vitrage (1) selon l'une des revendications 2 à 6, dans lequel chaque circuit électrique résonant (8) est un circuit électrique multi-résonnant.

8. Vitrage (1) selon l'une des revendications 1 à 7, dans lequel les circuits électriques résonants (8) sont situés sur une carte électronique (4) qui est déportée par rapport au substrat transparent (2).

9. Vitrage (1) selon l'une des revendications 1 à 8, comprenant entre 10 et 1000 transducteurs piézoélectriques transparents (3) par m$^2$, de préférence entre 10 et 200 par m$^2$.

10. Vitrage (1) selon l'une des revendications 1 à 9, dans lequel chaque transducteur piézoélectrique transparent (3) a une surface comprise entre 1 et 100 cm$^2$, de préférence entre 1 et 25 cm$^2$.

11. Vitrage (1) selon l'une des revendications 1 à 10, dans lequel chaque transducteur piézoélectrique transparent (3) a une épaisseur totale comprise entre 1 $\mu$m et 1 mm, de préférence entre 10 $\mu$m et 1mm, voire entre 10 $\mu$m et 500 $\mu$m.

12. Vitrage (1) selon l'une des revendications 1 à 10, dans lequel l'espace entre deux transducteurs piézoélectriques transparents (3) adjacents est compris entre 0,5 cm et 50 cm, de préférence entre 1 cm et 15 cm.

13. Vitrage (1) selon l'une des revendications 1 à 12, dans lequel le substrat transparent (2) comporte un réseau, de préférence périodique, de transducteurs piézoélectriques transparents (3) sur chacune de ses faces, les transducteurs piézoélectriques transparents (3) étant situés en vis-à-vis les uns des autres sur ses deux faces et chaque paire de transducteurs piézoélectriques transparents (3) situés en vis-à-vis étant reliés au même circuit électrique résonant (8).

14. Vitrage (1) selon l'une des revendications 1 à 13, dans lequel chaque transducteur piézoélectrique transparent (3) est à base d'oxyde de zinc, ou d'oxyde de titane et de baryum de type BaTiO$_3$, ou de nitrure d'aluminium, ou de Titano-Zirconate de Plomb (PZT), ou de polyfluorure de vinylidène (PVDF), ou de Titano-Zirconate de Plomb dopé au Lanthane (PLZT), ou encore de copolymère à bloc de poly(styrène-b-isoprène).

15. Vitrage (1) selon l'une des revendications 1 à 14, dans lequel le au moins un substrat transparent (2), comprend a) une première électrode transparente sous forme d'une couche mince disposée sur toute la surface du substrat transparent, ou une pluralité de premières électrodes transparentes sous forme d'une pluralité de portions de couche mince réparties de façon matricielle sur toute la surface du substrat transparent ; b) un élément piézoélectrique transparent sous forme d'une couche mince disposée sur toute la surface du substrat transparent, ou une pluralité d'éléments piézoélectriques transparents sous forme d'une pluralité de portions de couche mince réparties de façon matricielle, chaque élément piézoélectrique transparent étant disposé sur la première électrode transparente sous forme de couche mince ou sur une seule première électrode transparente sous forme d'une portion de couche mince, les éléments piézoélectriques transparents répartis de façon matricielle étant de préférence isolés les uns des autres par un matériau isolant ; et c) une pluralité de deuxièmes électrodes transparentes sous forme d'une pluralité de portions de couche mince réparties de façon matricielle, chaque deuxième électrode transparente étant disposée sur un seul élément piézoélectrique transparent ou au-dessus d'une seule première électrode transparente recouverte de l'élément piézoélectrique sous forme d'une couche mince disposée sur toute la surface du substrat transparent.

16. Vitrage (1) selon la revendication 15, dans lequel chaque électrode transparente est constituée d'un empilement de couches minces comprenant au moins une couche mince en oxyde transparent conducteur, par exemple en oxyde de titane, et/ou une couche mince métallique.

17. Vitrage (1) selon l'une des revendications 15 à 16, dans lequel au moins une couche mince diélectrique est disposée entre chaque première et deuxième électrodes transparentes et le ou les éléments piézoélectriques transparents.

18. Vitrage (1) selon l'une des revendications 1 à 17, constitué d'un vitrage feuilleté comprenant le substrat transparent (2) formant un méta-matériau, un intercalaire (7) en matériau viscoélastique, de préférence à base de polyvynibutyral, et un substrat transparent (6) ou un deuxième substrat transparent (2) formant un méta-matériau, les transducteurs piézoélectriques transparents (3) étant de préférence sur une face du substrat qui est en vis-à-vis de l'intercalaire (7).

19. Vitrage (1) selon l'une des revendications 1 à 17, constitué d'un vitrage isolant comprenant le substrat transparent (2) formant un méta-matériau, et un substrat transparent ou un deuxième substrat transparent (2) formant un méta-matériau, espacés par une lame d'air ou une lame de gaz, les transducteurs piézoélectriques transparents (3) étant de préférence sur une face du substrat qui est en vis-à-vis de la lame d'air ou de la lame de gaz.

**Patentansprüche**

1. Verglasung (1) mit verbesserter akustischer Leistung, wobei die Verglasung (1) mindestens ein transparentes Substrat (2) umfasst, das auf mindestens einer seiner Seiten ein vorzugsweise periodisches Netzwerk von transparenten piezoelektrischen Wandlern (3) aufweist,
   **dadurch gekennzeichnet, dass**
   die Verglasung eine Vielzahl von elektrischen Resonanzschaltungen (8) umfasst, wobei jeder transparente piezoelektrische Wandler (3) mit einer einzelnen elektrischen Resonanzschaltung (8) verbunden ist, so dass das transparente Substrat (2) ein transparentes Metamaterial bildet.

2. Verglasung (1) nach Anspruch 1, wobei jede elektrische Resonanzschaltung (8) eine passive oder halbpassive Schaltung ist.

3. Verglasung (1) nach Anspruch 2, wobei jede elektrische Resonanzschaltung (8) mindestens eine Induktivität umfasst, wobei die Induktivität entweder eine Spule oder eine synthetische Induktivität ist.

4. Verglasung (1) nach Anspruch 3, wobei jede elektrische Resonanzschaltung (8) ferner eine negative synthetische Kapazität umfasst.

5. Verglasung (1) nach einem der Ansprüche 3 oder 4, wobei jede elektrische Resonanzschaltung (8) ferner einen Widerstand umfasst.

6. Verglasung (1) nach einem der Ansprüche 3 bis 5, wobei jede elektrische Resonanzschaltung (8) ferner durch Regelung der Induktivität und/oder der Kapazität adaptiv ist.

7. Verglasung (1) nach einem der Ansprüche 2 bis 6, wobei jede elektrische Resonanzschaltung (8) eine elektrische Mehrfachresonanzschaltung ist.

8. Verglasung (1) nach einem der Ansprüche 1 bis 7, wobei sich die elektrischen Resonanzschaltungen (8) auf einer elektronischen Platine (4) befinden, die in Bezug auf das transparente Substrat (2) versetzt ist.

9. Verglasung (1) nach einem der Ansprüche 1 bis 8, umfassend zwischen 10 und 1000 transparente piezoelektrische Wandler (3) pro $m^2$, vorzugsweise zwischen 10 und 200 pro $m^2$.

**10.** Verglasung (1) nach einem der Ansprüche 1 bis 9, wobei jeder transparente piezoelektrische Wandler (3) eine Oberfläche zwischen 1 und 100 cm², vorzugsweise zwischen 1 und 25 cm², aufweist.

**11.** Verglasung (1) nach einem der Ansprüche 1 bis 10, wobei jeder transparente piezoelektrische Wandler (3) eine Gesamtdicke zwischen 1 $\mu$m und 1 mm, vorzugsweise zwischen 10 $\mu$m und 1 mm, oder sogar zwischen 10 $\mu$m und 500 $\mu$m aufweist.

**12.** Verglasung (1) nach einem der Ansprüche 1 bis 10, wobei der Abstand zwischen zwei benachbarten transparenten piezoelektrischen Wandlern (3) zwischen 0,5 cm und 50 cm, vorzugsweise zwischen 1 cm und 15 cm, beträgt.

**13.** Verglasung (1) nach einem der Ansprüche 1 bis 12, wobei das transparente Substrat (2) auf jeder seiner Seiten ein vorzugsweise periodisches Netzwerk von transparenten piezoelektrischen Wandlern (3) aufweist, wobei die transparenten piezoelektrischen Wandler (3) auf ihren beiden Seiten einander gegenüberliegend angeordnet sind und jedes Paar von einander gegenüberliegenden transparenten piezoelektrischen Wandlern (3) mit derselben elektrischen Resonanzschaltung (8) verbunden ist.

**14.** Verglasung (1) nach einem der Ansprüche 1 bis 13, wobei jeder transparente piezoelektrische Wandler (3) auf der Basis von Zinkoxid, oder Titan- und Bariumoxid vom Typ BaTiO$_3$, oder Aluminiumnitrid oder Blei-Titan-Zirkonat (PZT) oder Polyvinylidenfluorid (PVDF) oder Lanthan-dotiertes Blei-Titan-Zirkonat (PLZT) oder sogar Poly(styrol-b-isopren)-Blockcopolymer ist.

**15.** Verglasung (1) nach einem der Ansprüche 1 bis 14, wobei das mindestens eine transparente Substrat (2) a) eine erste transparente Elektrode in Form einer dünnen Schicht, die über die gesamte Oberfläche des transparenten Substrats angeordnet ist, oder eine Vielzahl von ersten transparenten Elektroden in Form einer Vielzahl von Abschnitten einer dünnen Schicht, die matrixartig über die gesamte Oberfläche des transparenten Substrats verteilt sind; b) ein transparentes piezoelektrisches Element in Form einer dünnen Schicht, die über die gesamte Oberfläche des transparenten Substrats angeordnet ist, oder eine Vielzahl von transparenten piezoelektrischen Elementen in Form einer Vielzahl von matrixförmig verteilten Abschnitten einer dünnen Schicht, wobei jedes transparente piezoelektrische Element auf der ersten transparenten Elektrode in Form einer dünnen Schicht oder auf einer einzelnen ersten transparenten Elektrode in Form eines Abschnitts einer dünnen Schicht angeordnet ist, wobei die matrixartig verteilten transparenten piezoelektrischen Elemente vorzugsweise durch ein isolierendes Material voneinander isoliert sind; und c) eine Vielzahl von transparenten zweiten Elektroden in Form einer Vielzahl von matrixartig verteilten Abschnitten einer dünnen Schicht umfasst, wobei jede transparente zweite Elektrode auf einem einzelnen transparenten piezoelektrischen Element oder über einer einzelnen transparenten ersten Elektrode angeordnet ist, die von dem piezoelektrischen Element in Form einer dünnen Schicht bedeckt ist, die über die gesamte Oberfläche des transparenten Substrats angeordnet ist.

**16.** Verglasung (1) nach Anspruch 15, wobei jede transparente Elektrode aus einem Stapel von dünnen Schichten besteht, der mindestens eine dünne Schicht aus einem leitfähigen transparenten Oxid, beispielsweise Titanoxid, und/oder eine dünne Metallschicht umfasst.

**17.** Verglasung (1) nach einem der Ansprüche 15 bis 16, wobei mindestens eine dielektrische dünne Schicht zwischen jeder ersten und zweiten transparenten Elektrode und dem transparenten piezoelektrischen Element oder den transparenten piezoelektrischen Elementen angeordnet ist.

**18.** Verglasung (1) nach einem der Ansprüche 1 bis 17, die aus einer Verbundverglasung besteht, die das transparente Substrat (2), das ein Metamaterial bildet, eine Zwischenlage (7) aus einem viskoelastischen Material, vorzugsweise auf der Basis von Polyvynibutyral, und ein transparentes Substrat (6) oder ein zweites transparentes Substrat (2) umfasst, das ein Metamaterial bildet, wobei sich die transparenten piezoelektrischen Wandler (3) vorzugsweise auf einer Seite des Substrats befinden, die der Zwischenlage (7) zugewandt ist.

**19.** Verglasung (1) nach einem der Ansprüche 1 bis 17, die aus einer Isolierverglasung besteht, die das transparente Substrat (2), das ein Metamaterial bildet, und ein transparentes Substrat oder ein zweites transparentes Substrat (2), das ein Metamaterial bildet, umfasst, die durch einen Luftspalt oder einen Gasspalt voneinander beabstandet sind, wobei sich die transparenten piezoelektrischen Wandler (3) vorzugsweise auf einer Seite des Substrats befinden, die dem Luftspalt oder dem Gasspalt zugewandt ist.

**Claims**

**1.** A glazing (1) having enhanced acoustic performance, the glazing (1) comprising at least one transparent substrate (2) including, on at least one of its faces, a, preferably periodic, array of transparent piezoelectric transducers (3),
**characterized in that**
the glazing (1) comprises a plurality of resonant electrical circuits (8), each transparent piezoelectric transducer (3) being connected to a single resonant electrical circuit (8) such that the transparent substrate (2) forms a transparent meta material.

2. The glazing (1) as claimed in claim 1, wherein each resonant electrical circuit (8) is a passive or semi-passive circuit.

3. The glazing (1) as claimed in claim 2, wherein each resonant electrical circuit (8) comprises at least one inductance, the inductance being either a coil or a synthetic inductance.

4. The glazing (1) as claimed in claim 3, wherein each resonant electrical circuit (8) further comprises a synthetic negative capacitance.

5. The glazing (1) as claimed in one of claims 3 or 4, wherein each resonant electrical circuit (8) further comprises a resistance.

6. The glazing (1) as claimed in one of claims 3 to 5, wherein each resonant electrical circuit (8) is furthermore adaptive through the inductance and/or the capacitance being adjusted.

7. The glazing (1) as claimed in one of claims 2 to 6, wherein each resonant electrical circuit (8) is a multi-resonant electrical circuit.

8. The glazing (1) as claimed in one of claims 1 to 7, wherein the resonant electrical circuits (8) are located on a circuit board (4) spaced apart from the transparent substrate (2).

9. The glazing (1) as claimed in one of claims 1 to 8, comprising between 10 and 1000 transparent piezoelectric transducers (3) per $m^2$, preferably between 10 and 200 per $m^2$.

10. The glazing (1) as claimed in one of claims 1 to 9, wherein each transparent piezoelectric transducer (3) has an area of between 1 and 100 $cm^2$, preferably between 1 and 25 $cm^2$.

11. The glazing (1) as claimed in one of claims 1 to 10, wherein each transparent piezoelectric transducer (3) has a total thickness of between 1 $\mu$m and 1 mm, preferably between 10 $\mu$m and 1 mm, or even between 10 $\mu$m and 500 $\mu$m.

12. The glazing (1) as claimed in one of claims 1 to 10, wherein the space between two adjacent transparent piezoelectric transducers (3) is between 0.5 cm and 50 cm, preferably between 1 cm and 15 cm.

13. The glazing (1) as claimed in one of claims 1 to 12, wherein the transparent substrate (2) includes a, preferably periodic, array of transparent piezoelectric transducers (3) on each of its faces, the transparent piezoelectric transducers (3) being located facing one another on its two faces and each pair of transparent piezoelectric transducers (3) located facing one another being connected to the same resonant electrical circuit (8).

14. The glazing (1) as claimed in one of claims 1 to 13, wherein each transparent piezoelectric transducer (3) is based on zinc oxide, or on an oxide of titanium and barium of the type $BaTiO_3$, or on aluminium nitride, or on lead zirconate titanate (PZT), or on polyvinylidene fluoride (PVDF), or on lanthanum-doped lead zirconate titanate (PLZT), or else on poly(styrene-b-isoprene) block copolymer.

15. The glazing (1) as claimed in one of claims 1 to 14, wherein the at least one transparent substrate (2) comprises a) a first transparent electrode in the form of a thin film arranged over the entire surface of the transparent substrate, or a plurality of first transparent electrodes in the form of a plurality of portions of thin film distributed in a matrix array over the entire surface of the transparent substrate; b) a transparent piezoelectric element in the form of a thin film arranged over the entire surface of the transparent substrate, or a plurality of transparent piezoelectric elements in the form of a plurality of portions of thin film distributed in a matrix array, each transparent piezoelectric element being arranged on the first transparent electrode in the form of a thin film or on a single first transparent electrode in the form of a portion of thin film, the transparent piezoelectric elements distributed in a matrix array preferably being insulated from one another by an insulating material; and c) a plurality of second transparent electrodes in the form of a plurality of portions of thin film distributed in a matrix array, each second transparent electrode being arranged on a single transparent piezoelectric element or on top of a single first transparent electrode covered with the piezoelectric element in the form of a thin film arranged over the entire surface of the transparent substrate.

16. The glazing (1) as claimed in claim 15, wherein each transparent electrode consists of a stack of thin films comprising at least one thin film of transparent conductive oxide, for example titanium oxide, and/or one metal thin film.

17. The glazing (1) as claimed in one of claims 15 or 16, wherein at least one dielectricthin film is arranged between each first and second transparent electrode and the one or more transparent piezoelectric elements.

18. The glazing (1) as claimed in one of claims 1 to 17, consisting of a laminated glazing comprising the transparent substrate (2) forming a metamaterial, an interlayer (7) made of viscoelastic material, preferably based on polyvinyl butyral, and a transparent substrate (6) or a second transparent substrate (2) forming a metamaterial, the transparent piezoelectric transducers (3) preferably being on a face of the substrate that is facing the interlayer (7).

19. The glazing (1) as claimed in one of claims 1 to 17, consisting of an insulating glazing comprising the transparent substrate (2) forming a metamaterial, and a transparent substrate or a second transparent substrate (2) forming a metamaterial, spaced apart by an air-filled cavity or a gas-filled cavity, the transparent piezoelectric transducers (3) preferably being on a face of the substrate that is facing the air-filled cavity or the gas-filled cavity.

**Fig.1**

3

2

1

**Fig.2**

10    4

5b

5a

8

3

5a

5b

10

2

1

**Fig.3**

3

3

2

1

**Fig.4**

**Fig.5**

Fig.6

**EP 3 803 018 B1**

## RÉFÉRENCES CITÉES DANS LA DESCRIPTION

**Documents brevets cités dans la description**

- WO 2013164540 A1